# EUROPEAN PATENT APPLICATION

(11) **EP 4 734 735 A1**
(43) Date of publication of application: **29.04.2026**
(21) Application number: 24208614.8
(22) Date of filing: 24.10.2024
(51) Int. Cl.: H10N 69/00, H10N 60/01, H10N 60/12

(54) **INTEGRATED CIRCUIT WITH SUPERCONDUCTING QUBIT AND TRANSISTOR INTEGRATION, METHOD FOR FABRICATING THE SAME, AND USE OF THE INTEGRATED CIRCUIT**

(71) Applicant: Terra Quantum AG, 9000 St. Gallen (CH)
(72) Inventor: Neukart, Florian, 9000 St. Gallen (CH); Vinokur, Valerii, 9000 St. Gallen (CH)
(74) Representative: Lucke, Andreas

(57) **Abstract**

An integrated circuit is provided, comprising a semiconductor layer, a superconducting qubit, a dielectric layer, and at least one electrical component. The semiconductor layer comprises a transistor. The superconducting qubit comprises a capacitor, a silicon nitride layer, and layers of high-critical-temperature superconductor material. The layers of high-critical-temperature superconductor material form a Josephson junction between them. The Josephson junction is electrically coupled to the capacitor. At least a section of the silicon nitride layer is arranged between the capacitor and the Josephson junction. The dielectric layer is arranged between the semiconductor layer and the superconducting qubit. The at least one electrical component couples the superconducting qubit to the transistor.

## Description

### FIELD OF THE DISCLOSURE

The present disclosure relates to a system and a method for integrating a high-critical-temperature superconductor qubit with semiconductor technology. Specifically, the present disclosure pertains to an integrated circuit integrating a high-critical-temperature superconductor qubit and at least one semiconductor layer with a transistor, separated by a dielectric layer between them, and to a method for fabricating such an integrated circuit.

### BACKGROUND

Classical computing has undergone tremendous advancements over the past decades, driving innovations across various fields. However, as we approach the physical limits of transistor miniaturization, power dissipation achieves a value that cannot be further decreased. This challenge is often referred to as the Boltzmann tyranny limit. This limit represents the fundamental barrier to reducing the power consumption of transistors, which is crucial for the continued scaling of computational devices.

Parallel to these advancements in classical computing, quantum computing has gained significant attention due to its potential to solve problems that are intractable for classical computers.

The intersection of classical and quantum computing has been an area of intense research, particularly as both fields have seen significant advancements.

### SUMMARY OF THE DISCLOSURE

It is a feature of the present disclosure to provide an improved integration of semiconductor technology, in its prototypical form being a transistor, with quantum computer technology, in its prototypical form being a qubit, thus overcoming one or more of the disadvantages of known systems.

According to a first aspect of the disclosure, an integrated circuit is provided, comprising a semiconductor layer, a superconducting qubit, a dielectric layer, and at least one electrical component. The semiconductor layer comprises a transistor. The superconducting qubit comprises a capacitor, a silicon nitride layer, and layers of high-critical-temperature superconductor material. The layers of high-critical-temperature superconductor material form a Josephson junction between them. The Josephson junction is electrically coupled to the capacitor. At least a section of the silicon nitride layer is arranged between the capacitor and the Josephson junction. The dielectric layer is arranged between the semiconductor layer and the superconducting qubit. The at least one electrical component couples the superconducting qubit to the transistor.

The semiconductor layer, which includes a transistor, serves as the classical computing component of the integrated circuit.

The semiconductor layer is able to provide a logical circuit for performing classical logic operations, which form the basic building blocks for classical computation.

The semiconductor layer is further able to provide a memory circuit for storing information in a classical (binary) information representation. For example, the information stored in the classical information representation may include intermediate results from the operation of the superconducting qubit.

The semiconductor layer is further able to provide a control circuit for managing initialization, manipulation, and readout of the superconducting qubit, and for facilitating communication between the semiconductor layer and the superconducting qubit. The control circuits may contribute to or perform initializing, manipulating, and readout of the quantum-mechanical state the superconducting qubit.

The superconducting qubit facilitates quantum operations, entanglement and superposition, thus enabling quantum computation.

Here and in the following, a device coupling a semiconductor layer comprising a transistor and a superconducting qubit, such as the integrated circuit according to the first aspect, is referred to as a hybrid quantum computer.

Being more specific than a hybrid quantum computer, here and in the following, a device coupling a semiconductor layer comprising a transistor and a superconducting qubit with a Josephson junction formed between layers of high-critical-temperature superconductor material, such as the integrated circuit according to the first aspect, is referred to as a high-critical-temperature hybrid quantum computer.

A hybrid quantum computer has the potential to excel (i.e., as compared to a classical, semiconductor-based computer without a qubit such as a superconducting qubit) in solving optimization problems, linear systems, factorization, quantum chemistry, Monte Carlo simulations, machine learning, and physical system simulations. Quantum computation can handle tasks like optimization (e.g., NP-hard problems), fast matrix inversion, cryptographic challenges (e.g., RSA), and molecular simulations far more efficiently due to superposition and entanglement, while classical computers manage data preparation, pre/post-processing, and overall system control. For problems like Monte Carlo simulations, quantum parallelism reduces the number of samples needed. Quantum machine learning can accelerate specific tasks like clustering and classification, while classical systems handle the data pipeline. In cryptography and quantum communication, quantum processors offer secure methods (e.g., quantum key distribution) while classical systems manage data transmission. The hybrid quantum computer maximizes both quantum speedups and classical computational power, effectively solving problems that are intractable for classical computers alone.

Existing hybrid quantum computers suffer from a long latency in the communication between the semiconductor layer serving as a classical computing component (e.g., as a logical circuit for performing classical logic operations, as a memory circuit for storing information in the classical information representation, and/or as a control circuit for managing initialization, manipulation, and readout of the superconducting qubit) and the superconducting qubit(s) facilitating quantum operations and enabling quantum computation. In conventional approaches, the superconducting qubit(s) during operation is/are typically arranged inside a dilution refrigerator cooling the superconducting qubit(s) to a temperature below the boiling point of helium (4.2 K), while the semiconductor layer serving as the classical computing component is located outside of the dilution refrigerator. Communication between those two components is facilitated via an electromagnetic wave, for example in the form of light in a fiber or in the form of a microwave. The communication thus requires the generation and detection of said electromagnetic wave, which is time-consuming and a main source of the latency between the classical computing performed using the semiconductor layer and the quantum computing performed using the superconducting qubit(s).

The integrated circuit according to the first aspect reduces the latency by integrating the semiconductor layer and the superconducting qubit in an integrated circuit, resulting in short communication pathways.

The integration further gives the possibility to couple the semiconductor layer and the superconducting qubit in a variety of ways, including capacitive and direct electrical coupling, thus avoiding time-consuming electromagnetic wave generation and detection.

The integration benefits from the use of a Josephson junction of the superconducting qubit formed between layers of high-critical-temperature superconductor material. The use of high-critical-temperature superconductor material relaxes the requirements to the cooling of the superconducting qubit. In other words, the superconducting qubit can be operated at a high temperature, as compared to the operation of conventional superconducting qubits using a Josephson junction between high-critical-temperature superconductor materials such as elemental metals, alloys of elemental metals, or nitrides of elemental metals. In yet other words, waste heat produced in the semiconductor layer is less problematic for the superconducting qubit using high-critical-temperature superconductor material, as compared to a conventional qubit of a conventional hybrid quantum computer using a superconducting qubit with a Josephson junction between low-critical-temperature superconductor material(s).

The practical implementation of a hybrid quantum computer with a Josephson junction formed between layers of high-critical-temperature superconductor material is thus a major advantage of the invention.

The use of a Josephson junction formed between layers of high-critical-temperature superconductor material also relaxes the requirements to the dielectric layer between the semiconductor layer and the superconducting qubit to ensure thermal insulation between the two. In view of those reduced thermal insulation requirements, the dielectric layer of the integrated circuit according to the first aspect ensures sufficient thermal insulation between the semiconductor layer and the superconducting qubit for reliable, synchronous operation of both of them. For example, a sufficient thermal insulation may be provided using a dielectric layer comprising or consisting of silicon oxide or a high-k dielectric. In the context of this disclosure, a high-k material is a material having a static dielectric constant of at least seven. Examples of high-k materials are silicon nitride, aluminum oxide, tantalum oxide, titanium oxide, strontium titanium oxide, zirconium oxide, hafnium oxide, hafnium silicon oxide, lanthanum oxide, yttrium oxide or lanthanum aluminum oxide. Herein, the symbol k refers to the static dielectric constant.

The dielectric layer further provides electrical insulation between the semiconductor layer and the superconducting qubit(s).

The dielectric layer further minimizes cross-talk and interference between the semiconductor layer and the superconducting qubit(s).

The implementation of the high-critical-temperature hybrid quantum computer according to the first aspect benefits significantly from the applied silicon nitride layer.

In particular, the applied silicon nitride layer beneficially facilitates the fabrication of the respective high-critical-temperature hybrid quantum computer. Silicon nitride is particularly suitable for microprocessing. Techniques for processing silicon nitride have been highly developed in the semiconductor industry. The developed techniques include photolithography for patterning a silicon nitride layer by coating it with a photoresist, exposing it to UV light through a mask, and then etching away the unexposed areas to create precise features. The developed techniques also include reactive ion etching, which is used to etch silicon nitride with high precision, employing plasma to remove material in a controlled manner for applications such as defining patterns in integrated circuits and MEMS (micro-electro-mechanical systems) devices. Silicon nitride layers have been processed using wet etching, which uses chemical solutions to etch away silicon nitride selectively. Dry etching, including deep reactive ion etching, is applied to achieve high aspect ratio structures. Anisotropic etching has been utilized to create well-defined, directional etch profiles. Chemical-mechanical planarization has been performed to polish and smooth the silicon nitride surface, ensuring planarity before further processing steps. This portfolio of processing techniques beneficially facilitates the fabrication of the superconducting qubit with the Josephson junction formed between layers of high-critical-temperature superconductor material.

The integrated circuit according to the first aspect further beneficially makes use of the excellent properties of silicon nitride as a passivation material. Silicon nitride has been widely used for passivation and encapsulation since it provides electrical insulation, chemical stability, and thermal stability. In semiconductor devices, it has been employed as a passivation layer to protect sensitive components from environmental contamination, such as moisture and ionic impurities, and helps prevent oxidation of underlying materials. It is commonly employed in the fabrication of integrated circuits, solar cells, and MEMS to enhance durability and performance. In light-emitting diodes manufacturing, silicon nitride encapsulates the device to improve light output and reliability by reducing surface recombination. In thin-film transistors, particularly in organic light-emitting diodes, it acts as a protective layer to the thin-film transistor improving its electrical performance and stability.

In the integrated circuit according to the first aspect, the silicon nitride layer preferably forms at least a portion of an encapsulation of the layers of high-critical-temperature superconductor material. Since high-critical-temperature superconductor materials are typically prone to chemical decomposition, in particular in the presence of oxygen and/or water, the use of silicon nitride can thus reduce or prevent a respective chemical composition through said encapsulation.

According to an embodiment, the dielectric layer is arranged above the semiconductor layer, and the superconducting qubit is arranged above the dielectric layer.

Alternatively, or in addition, the dielectric layer may be arranged above the transistor such that a vertical reference line intersects both the dielectric layer and the transistor.

Alternatively, or in addition, the superconducting qubit may be arranged above the transistor such that a vertical reference line intersects both the dielectric layer and the transistor.

Alternatively, or in addition, the Josephson junction may be formed by said layers of high-critical-temperature superconductor material being arranged above one another.

According to an embodiment, the capacitor, the silicon nitride layer, and the Josephson junction are arranged above one another. In respective embodiments, the silicon nitride layer may be arranged above the Josephson junction and the capacitor may be arranged above the silicon nitride layer.

Respective embodiments can be fabricated with a minimized number of fabrication steps, as is laid out in detail in the context of the method according to the second embodiment. In other words, respective integrated circuits can be fabricated readily and in an economical manner.

Moreover, in respective embodiments, the silicon nitride layer may provide at least part of an encapsulation to the Josephson junction, which is formed between sensitive high-critical-temperature superconductor materials.

The high-critical-temperature superconductor material of a first one of the layers of high-critical-temperature superconductor material forming the Josephson junction may comprise or consist of a cuprate such as BSCCO, or an iron based high temperature superconductors (e.g., FeSe, potassium doped FeSe, FeSexTe1-x).

In the context of this disclosure, the term BSCCO refers to a material with the chemical composition Bi₂Sr₂Caₙ₋₁CuₙO₂ₙ₊₄₊ₓ where n = 2, 3, 4.

Preferably, the high-critical-temperature superconductor material comprises or is BSCCO.

The high-critical-temperature superconductor material of a second one of the layers of high-critical-temperature superconductor material forming the Josephson junction may comprise or consist of a cuprate such as BSCCO, or an iron based high temperature superconductors (e.g., FeSe, potassium doped FeSe, FeSexTe1-x). Preferably, said high-critical-temperature superconductor material comprises or is BSCCO.

The high-critical-temperature superconductor material of the layers of high-critical-temperature superconductor material forming the Josephson junction or of at least one of the layers of high-critical-temperature superconductor material forming the Josephson junction may comprise or consist of van der Waals materials.

According to some embodiments, the high-critical-temperature superconductor material of the first one and the second one of the layers of high-critical-temperature superconductor material forming the Josephson junction comprise a same material or are composed of the same material.

In the context of this disclosure, a qubit may refer to a quantum mechanical two-level system suitable for quantum information processing. A quantum mechanical two-level system may be a system having at least two distinct quantum states, and any higher number of distinct quantum states, in particular any integer number of distinct quantum states. High-critical-temperature superconducting qubits can be adapted to implement quantum mechanical two-level systems.

A Josephson junction can be adapted to provide multiple quantum mechanical states. In particular, a Josephson junction can be adapted to provide a first quantum mechanical state of a quantum mechanical two-level system and a second quantum mechanical state of a quantum mechanical two-level system. The first quantum mechanical state and the second quantum mechanical state may be states of the plurality of quantum mechanical states having the lowest energies. In particular, the first quantum mechanical state of the quantum mechanical two-level system may be the ground state of a plurality of quantum mechanical states. In particular, the second quantum mechanical state of the quantum mechanical two-level system may be the lowest energy excited state of the plurality of quantum mechanical states. The first quantum mechanical state is the second quantum state, particularly in terms of energy, spin, spatial distribution, charge on the Josephson junction, direction of current through the Josephson junction, and/or phase of current through the Josephson junction. It may be different from the mechanical state. In particular, the energy difference between the second state and the first state may be different than the energy difference for any pair of states of the plurality of quantum mechanical states.

The silicon nitride layer may be sufficiently thin for the silicon nitride layer or for a capacity layer comprising the silicon nitride layer to be mechanically flexible.

Alternatively, or in addition, the silicon nitride layer and/or the capacitor layer may have a thickness of 1 µm or less, or of 0.6 µm or less. In particular, the silicon nitride layer may have a thickness in a range from 300 nm to 600 nm.

According to an embodiment, each of the layers of high-critical-temperature superconductor material comprises or is a layer of an anisotropic, crystallographically layered material.

In respective embodiments, the anisotropic, crystallographically layered material may comprise a c-axis perpendicular to covalently bound atomic layers of the anisotropic, crystallographically layered material.

In respective embodiments, the c-axis may be orientated along a vertical direction.

In respective embodiments, the covalently bound atomic layers of one of the layers of anisotropic, crystallographically layered material may be rotated about the c-axis with respect to the covalently bound atomic layers of another one of the layers of an anisotropic, crystallographically layered material at the Josephson junction.

In the context of this disclosure, a respective arrangement of the layers of anisotropic, crystallographically layered material is also referred to as a twisted van-der-Waals Josephson junction.

A respective arrangement of the layers of anisotropic, crystallographically layered material maximizes the coherence time of the qubit device.

More specifically, this arrangement suppresses single-Cooper pair tunneling *E_{J},* or the Josephson energy, *E_{J},* respectively. The inventors have verified the finding of a suppressed Josephson energy *E_{J}* using simulations for BSCCO, and more specifically for Bi₂Sr₂CaCu₂O₈₊ₓ. It is similarly expected for other d-wave superconductors (or high-critical temperature superconductors, respectively, or superconductors comprising anisotropic, layered superconductor material, respectively), in particular for those with an angle of approximately 90° between their primitive lattice vectors perpendicular to the axis c.

The Josephson energy is directly related to the critical current *I_{c}* of the Josephson junction as *E_{J} = I_{c}*Φ₀/2π where Φ₀ *= h*/*2e* is the flux quantum. In this situation, two-Cooper pair tunneling is still possible, and the two-Cooper pair tunneling energy *Eₖ* is similar to the Josephson energy, E_{J}. The two-Cooper pair tunneling term can be written as *E_{κ}*cos (2*ϕ*), forming a double-well potential. In preferred embodiments, the corresponding two lowest-energy eigenstates are used to provide the two-level system of the qubit device. The energy difference between the respective eigenstates of the two-level is small, i.e., within an energy/frequency difference of up to 2 GHz, and in some embodiments up to 1 GHz. The respective eigenstates are therefore referred to as quasi-degenerate. The degeneracy goes hand in hand with, and therefore indicates a situation in which dielectric losses and crosstalk between qubit devices (i.e., between the quantum-mechanical states of their respective two-level systems) are drastically reduced. Those dielectric losses and crosstalk are the main limitations of conventional transmon qubits.

Thus, the relaxation time of the superconducting qubit according to respective embodiments (i.e., with the twisted van-der-Waals Josephson junction) is improved significantly as compared to the relaxation time in a conventional qubit device, e.g., of the transmon type. According to simulations performed by the inventors, the improvement amounts to a factor of 10.000, leading to coherence times up to 1 s.

In particular, the covalently bound atomic layers of one of the layers of anisotropic, crystallographically layered material may be rotated about the c-axis with respect to the covalently bound atomic layers of another one of the layers of an anisotropic, crystallographically layered material at the Josephson junction in terms of a first orientation of the one of the layers of anisotropic, crystallographically layered material and a second orientation of the other one of the layers of an anisotropic, crystallographically layered material.

The first/second orientation may correspond to a lattice vector of the anisotropic, crystallographically layered material of the one/another one of the layers of anisotropic, crystallographically layered material, in particular to a lattice vector parallel to the covalently bound atomic layers of the anisotropic, crystallographically layered material of the one/another one of the layers of anisotropic, crystallographically layered material.

A high-critical-temperature superconductor material may have a critical temperature of at least 4 K or at least 8 K or at least 15 K or at least 30 K or at least 50 K or at least 70 K or at least 78 K.

A high-critical-temperature superconductor material may be a type-II superconductor material.

A high-critical-temperature superconductor material may be a d-wave superconductor material.

A high-critical-temperature superconductor material may comprise oxygen or a chal-cogenide, in particular to at least 20 atomic percent or at least 30 atomic percent.

In embodiments, wherein the covalently bound atomic layers of one of the layers of anisotropic, crystallographically layered material are rotated about the c-axis with respect to the covalently bound atomic layers of another one of the layers of an anisotropic, crystallographically layered material, the rotation angle may be in a range from 38 to 44.9°.

A respective angle maximizes the coherence time of the qubit device, in particular for high-critical-temperature superconductor materials with an angle of approximately 90° between their in-plane primitive lattice vectors, such as BSCCO (i.e., Bi₂Sr₂Caₙ₋₁CuₙO₂ₙ₊₄₊ₓ). Said in-plane primitive lattice vectors may be in-plane with respect to the covalently bound atomic layers. In some embodiments, the in-plane primitive lattice vectors may be horizontal, in particular, wherein the covalently bound atomic layers extend in corresponding horizontal planes.

According to an embodiment, the at least one electrical component coupling the superconducting qubit to the transistor comprises an electrically conductive line arranged in the dielectric layer and/or the superconducting qubit is coupled to the transistor through the dielectric layer.

Alternatively, or in addition, the superconducting qubit may comprise a first bond pad, and the at least one electrical component coupling the superconducting qubit to the transistor may comprise the first bond pad.

The first bond pad may be arranged on the silicon nitride layer.

The inclusion of a first bond pad on the superconducting qubit facilitates a robust and reliable connection point for interfacing with the semiconductor layer comprising the transistor. Placing the first bond pad on the silicon nitride layer ensures that the connection is stable and well-insulated, which can improve the durability and performance of the integrated circuit by reducing the risk of connection failures and signal degradation.

Alternatively, or in addition, the dielectric layer may be provided with a second bond pad, and the at least one electrical component coupling the superconducting qubit to the transistor may comprise the second bond pad.

The second bond pad may be arranged on the dielectric layer.

Alternatively, or in addition, the at least one electrical component coupling the superconducting qubit to the transistor may comprise an electrically conductive line arranged in the silicon nitride layer and/or the superconducting qubit may be coupled to the transistor through the silicon nitride layer.

According to an embodiment, the superconducting qubit is capacitively coupled to the transistor. Alternatively, or in addition, the at least one electrical component coupling the superconducting qubit to the transistor may comprise or be a coupling capacitor.

An efficient and small-latency coupling between the semiconductor layer and the superconducting qubit of a hybrid quantum computer is a remarkably challenging task. Capacitive coupling provides a viable solution to this problem, providing a reduced latency. Moreover, the capacitive coupling facilitates efficient state transfer and synchronization.

Preferably, the coupling capacitor comprises a high-k dielectric. This ensures high capacitance values and low leakage currents.

Here and in the following, an electrode or electrodes of the coupling capacitor are referred to as coupling capacitor electrode or electrodes.

According to some embodiments, each coupling capacitor electrode of the coupling capacitor comprises or is composed of a superconducting material, for example niobium or aluminum. In use cases, where the integrated circuit is operated below the critical temperature of said superconducting material, the use of the superconductor material for the electrodes minimizes resistive losses and improves the maintenance of coherence.

Preferably, the coupling capacitor has a negative capacitance.

In a preferred embodiment, the coupling capacitor comprises a first coupling capacitor electrode, a second coupling capacitor electrode, and a ferroelectric structure arranged between the first coupling capacitor electrode and the second coupling capacitor electrode.

In respective embodiments, the ferroelectric structure may comprise a plurality of ferroelectric polarization domains and at least one ferroelectric domain wall. In respective embodiments, optionally, the ferroelectric structure arranged between the first coupling capacitor electrode and the second coupling capacitor electrode may have a cross-sectional area with an orientation corresponding to an orientation of a surface of the first coupling capacitor electrode facing the ferroelectric structure or of a surface of the second coupling capacitor electrode facing the ferroelectric structure, the cross-sectional area defining a shortest separation line to divide the cross sectional-area into a plurality of regions of essentially equal area, in particular into two regions of essentially equal area. In said embodiment, a reference line, which is, by definition, shifted with respect to said shortest separation line and which is, by definition, in a surface defined by the cross-sectional area, has a length within the cross-sectional area shorter than a length of the shortest separation line within the cross-sectional area, wherein a difference between said lengths increases with increasing distance between the reference line and the shortest separation line in a vicinity of the shortest separation line. This ensures suitable ferroelectric polarization domains and a suitable at least one ferroelectric domain wall for the coupling capacitor to provide a stable negative capacitance, as described in detail in EP 4 075 481 A1.

The ferroelectric structure may comprise or be composed of the ferroelectric material. For example, the ferroelectric material may be hafnium oxide (HfO₂) comprising a dopant or hafnium zirconium oxide (Hf_{0.5}Zr_{0.5}O₂), optionally comprising a dopant.

Respective embodiments beneficially provide a coupling capacitor with a stable negative capacitance, as described in detail in EP 4 075 481 A1. EP 4 075 481 A1 is incorporated herein in its entirety by reference.

By tuning the capacitance of the coupling capacitor couple through the negative capacitance effect, the interaction strength between the semiconductor layer and the superconducting qubit can be optimized for efficient state transfer. The coupling strength can be dynamically adjusted using the negative capacitance properties of a respective coupling capacitor, optimizing the interaction for various quantum operations. This dynamic adjustment beneficially improves maintaining high fidelity in-state transfer between the semiconductor layer and the superconducting qubit. The negative capacitance effect allows for rapid and precise control of the coupling capacitance, optimizing the interaction for various quantum operations. Utilizing the negative capacitance properties of the coupling capacitor helps to achieve rapid and precise voltage adjustments. This allows for fine-tuned control signals which is beneficial for qubit initialization and manipulation.

According to an embodiment, the capacitor comprises a first electrode and a second electrode, wherein the integrated circuit further comprises a first interconnect and a second interconnect, the first interconnect electrically connecting the first electrode and a first one of the layers of high-critical-temperature superconductor material, and the second interconnect electrically connecting the second electrode and a second one of the layers of high-critical-temperature superconductor material.

Said first and second ones of the layers of high-critical-temperature superconductor material may form the Josephson junction.

Alternatively, or in addition, the first interconnect and/or the second interconnect may comprise or be a vertical interconnect.

According to an embodiment, the integrated circuit further comprises a horizontal reference plane intersecting both the first electrode and the second electrode. Alternatively, or in addition, the first electrode and/or the second electrode may extend along said horizontal reference plane.

A respective integrated circuit can readily be fabricated making use of the silicon nitride layer, as is laid out in detail in the context of the method.

Moreover, respective embodiments ensure a precise alignment of the first and second electrodes. This alignment improves the consistency and predictability of the electrical characteristics between the electrodes, enhancing the overall performance and reliability of the superconducting qubit. The precise alignment also facilitates easier integration and manufacturing processes, reducing potential errors and variations in the production of the integrated circuit.

According to an embodiment, the integrated circuit comprises an encapsulation, said encapsulation encapsulating the layers of high-critical-temperature superconductor material forming the Josephson junction, wherein the encapsulation is formed at least in part by the silicon nitride layer.

The encapsulation formed at least in part by the silicon nitride layer provides a protective barrier around the layers of high-critical-temperature superconductor material forming the Josephson junction. This protective barrier helps to shield the sensitive high-critical-temperature superconductor material from environmental factors such as moisture, dust, and other contaminants that could degrade their performance. The use of silicon nitride, known for its excellent insulating properties and chemical stability, ensures that the encapsulation does not interfere with the electrical characteristics of the Josephson junction, thereby maintaining the integrity and reliability of the superconducting qubit.

The encapsulation may be formed at least in part by the dielectric layer.

The encapsulation may be a water tight and/or moisture-tight encapsulation.

The encapsulation may be an air-tight encapsulation.

According to an embodiment, the semiconductor layer and/or the superconducting qubit is in direct physical contact with the dielectric layer.

Direct physical contact between the semiconductor layer and the dielectric layer, or alternatively, between the superconducting qubit and the dielectric layer, enhances the structural integrity and stability of the integrated circuit. Additionally, it simplifies the manufacturing process, for example as the dielectric layer can be deposited directly over the semiconductor layer, allowing for the silicon nitride layer with a superconducting qubit to be placed thereon.

According to an embodiment, the semiconductor layer comprises a heating element adapted to provide heat to the transistor, in particular, wherein the heating element is arranged in a vicinity of the transistor.

The heating element provides localized heating to the transistor, which can be beneficial for maintaining optimal operating temperatures, especially in low-temperature environments where superconducting qubits are typically used. By ensuring the transistor operates within its ideal temperature range, the heating element enhances the performance and reliability of the transistor. This localized heating can prevent performance degradation due to cold-induced effects, thereby improving the overall stability and efficiency of the integrated circuit.

According to an embodiment, the at least one electrical component coupling the superconducting qubit to the transistor couples a gate of the transistor to the capacitor.

According to some embodiment, the transistor comprises a gate capacitor having a negative capacitance, preferably a stable negative capacitance. Alternatively, or in addition, the transistor may be a negative-capacitance transistor.

In respective embodiments, the at least one electrical component coupling the superconducting qubit to the transistor preferably comprises a coupling capacitor comprising a first coupling capacitor electrode, a second coupling capacitor electrode, and a ferroelectric structure arranged between the first coupling capacitor electrode and the second coupling capacitor electrode. Even more preferably, the respective coupling capacitor is comprised in a gate structure of the transistor.

Respective embodiments implement a transistor with a negative gate capacitance (also referred to as a negative-capacitance transistor in the context of this disclosure), and more specifically with a stable negative gate capacitance, as described in detail in EP 4 075 481 A1.

The transistor with the negative gate capacitance has an effectively lowered subthreshold swing below the Boltzmann limit, enabling faster and more energy-efficient operation of the integrated circuit.

The negative gate capacitance enhances the performance of the classical computer implemented in the semiconductor layer, such as the performance of a logic circuit implemented in the semiconductor layer.

The negative-capacitance transistor also facilitates a dynamic adjustment of a coupling strength between the semiconductor layer and the superconducting qubit, improving the performance of the superconducting qubit.

According to some embodiments, the at least one electrical component couples the gate of the transistor to the first electrode or to the second electrode of the capacitor.

According to an embodiment, the superconducting qubit is coupled to the transistor via a microwave resonator.

Alternatively, or in addition, the at least one electrical component coupling the superconducting qubit to the transistor may comprise or be at least one microwave resonator.

Including a microwave resonator as part of the electrical component that couples the superconducting qubit to the transistor provides a communication through a robust, well-developed coupling scheme.

A second aspect regards a method for fabricating an integrated circuit. Said method comprises providing a semiconductor layer and a dielectric layer over the semiconductor layer, the semiconductor layer comprising a transistor. Said method further comprises providing a capacitor layer separate from the semiconductor layer and separate from the dielectric layer, the capacitor layer comprising a silicon nitride layer, a capacitor and electrical coupling elements, the capacitor comprising a first electrode and a second electrode, wherein the electrical coupling elements comprise a first electrical coupling element in electrical contact with the first electrode and a second electrical coupling element in electrical contact with the second electrode. Said method further comprises providing layers of high-critical-temperature superconductor material, said layers of high-critical-temperature superconductor material forming a Josephson junction between them. The method further comprises arranging the capacitor layer and the layers of high-critical-temperature superconductor material over the semiconductor layer and the dielectric layer, such that the capacitor, the silicon nitride layer, and the layers of high-critical-temperature superconductor material form a superconducting qubit and such that the dielectric layer is arranged between the semiconductor layer and the superconducting qubit, wherein in the superconducting qubit the Josephson junction is electrically coupled to the capacitor through the first electrical coupling element and the second electrical coupling element and at least a section of the silicon nitride layer is arranged between the capacitor and the Josephson junction.

This fabrication method, by providing the capacitor layer separate from the semiconductor layer and arranging it thereover at a later step, ensures minimum damage to the Josephson junction, or to the high-critical-temperature superconductor material(s), respectively, during fabrication.

The method may further comprise cooling the Josephson junction to a temperature below a first temperature while the capacitor layer and the layers of high-critical-temperature superconductor material are arranged over the semiconductor layer and the dielectric layer, wherein the first temperature is o°C, or 250 K, or 230 K, or 210 K, or 190 K, or 170 K, or 150 K, or 130 K.

The cooling further reduces any damage to the Josephson junction, or to the high-critical-temperature superconductor material(s), respectively, during fabrication.

The arranging the capacitor layer over the semiconductor layer and the dielectric layer and/or the arranging the layers of high-critical-temperature superconductor material over the semiconductor layer and the dielectric layer may comprise attaching a transfer device to the capacitor layer; and cooling the transfer device to a temperature below a second temperature to attach the transfer device to the capacitor layer. The transfer device may be adapted to provide a strong adhesion when a temperature of the transfer device is below the second temperature and to provide a weak adhesion when the temperature of the transfer device is above the second temperature. In particular, the transfer device may be adapted to provide a weak adhesion when the temperature of the transfer device is above a third temperature exceeding the second temperature.

The respective transfer device permits to reliably pick up and to place the capacitor layer at a reduced (i.e., below the first temperature) fabrication temperature.

The transfer device may comprise or be composed of an elastomer.

The second temperature may correspond to the glass transition temperature of the elastomer or may exceed the glass transition temperature of the elastomer.

The third temperature may exceed a glass transition temperature of the elastomer.

The elastomer may be PTFE (polytetrafluoroethylene) or PDMS (polydimethylsiloxan).

The arranging the capacitor layer over the Josephson junction may comprise releasing the transfer device from the capacitor layer, wherein the releasing the transfer device from the capacitor layer comprises heating the transfer device, in particular to a temperature exceeding the second temperature, in particular to a temperature exceeding the third temperature.

A respective assembly of the integrated circuit by placing the capacitor layer and the layers of high-critical-temperature superconductor material over the semiconductor layer and the dielectric layer using a the described transfer device provides a sufficiently mild handling of the high-critical-temperature superconductor material to ensure that, during the fabrication process, the Josephson junction remains unaffected and undamaged. This is a major advantage over fabrication methods using material deposition, for example from the vapor phase, into which the material to be deposited is brought by thermal evaporation or ion bombardment. Performing thermal evaporation or ion bombardment in a vicinity of the high-critical-temperature superconductor material typically causes severe damage to the delicate high-critical-temperature superconductor material, affecting the performance of the Josephson junction.

A third aspect refers to a use of an integrated circuit according to any of the embodiments described above, wherein said use comprises bringing a cooling element having a temperature below 80 K in direct physical contact with the superconducting qubit.

### LIST OF FIGURES

In the following, a detailed description of the present disclosure and examples thereof is given with reference to the figures, wherein
Fig. 1 shows an integrated circuit according to an embodiment;
Fig. 2 shows an integrated circuit according to another embodiment;
Fig. 3 gives a detailed view of an anisotropic, crystallographically layered material;
Fig. 4a shows in detail a Josephson junction formed between layers of high-critical-temperature superconductor material, according to a perspective view;
Fig. 4b shows in detail the Josephson junction formed between layers of high-critical-temperature superconductor material, according to a top view;
Fig. 5 shows an integrated circuit according to another embodiment;
Fig. 6 shows an integrated circuit according to another embodiment;
Fig. 7a, Fig. 7b show an integrated circuit according to another embodiment;.
Fig. 8 to Fig. 12 each show an integrated circuits according to a different, further embodiment;
Fig. 13 illustrates a method according to an embodiment;
Fig. 14 illustrates a method according to another embodiment;
Fig. 15 illustrates a use according to an embodiment; and
Fig. 16 illustrates a use according to another embodiment.

### DESCRIPTION OF EXAMPLES

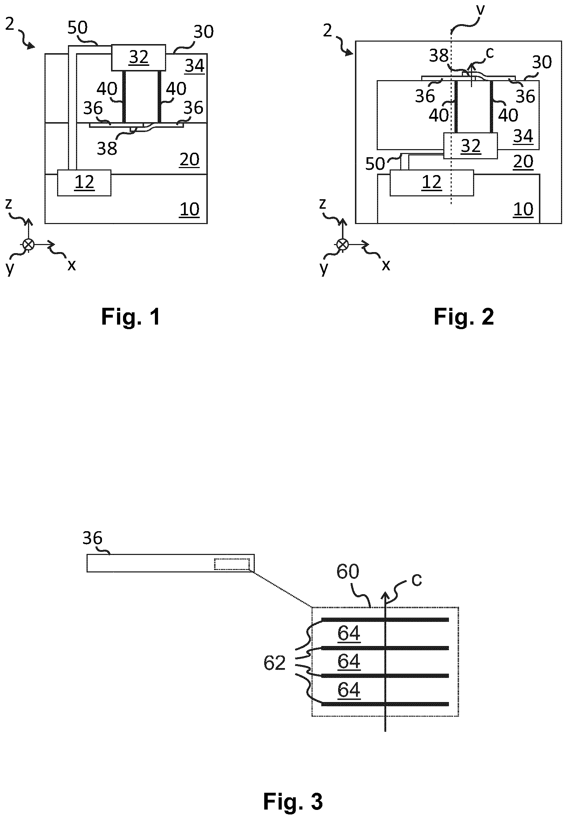

Fig. 1 shows an integrated circuit 2 comprising a semiconductor layer 10 with a transistor 12, a dielectric layer 20, and a superconducting qubit 30. The superconducting qubit 30 includes a capacitor 32, a silicon nitride layer 34, and layers of high-critical-temperature superconductor material 36 forming a Josephson junction 38. At least one electrical component 50 couples the superconducting qubit 30 to the transistor 12.

The Josephson junction 38 is electrically coupled to the capacitor 32 in the superconducting qubit 30. In the depicted embodiment, this is achieved via electrical coupling elements 40 through the silicon nitride layer 34. Respective electrical coupling elements 40 are optional. In alternative embodiments (not shown), the Josephson junction 38 is electrically coupled to the capacitor 32 through electrical lines around the silicon nitride layer 34.

In the depicted embodiment, using the transistor 12, the semiconductor layer 10 provides a logical circuit for performing classical logic operations, a memory circuit for storing information in a classical (binary) information representation, or a control circuit for at least one of: managing initialization, manipulation, and readout of the superconducting qubit, and for facilitating communication between the semiconductor layer and the superconducting qubit.

In alternative embodiments (not shown) the semiconductor layer 10 comprises a plurality of transistors including the transistor 12, the plurality of transistors providing at least two or each of the logical circuit, the memory circuit, and the control circuit. In some respective embodiments, the semiconductor layer 10 comprises or is a multi-chip module. In other words, the term semiconductor layer 10 is not to be construed as limiting to a single semiconductor layer 10, but, according to some embodiments, refers to at least one semiconductor layer 10, for example in the form of a multi-chip module 10.

Preferably, the semiconductor layer 10 comprises silicon, and the transistor 12 comprises silicon. However, alternatively, the semiconductor layer 10 and the transistor 12 comprise or are made from another semiconductor material such as silicon germanium, germanium, silicon carbide, or a III-V semiconductor such as gallium arsenide.

The superconducting qubit 30 facilitates quantum operations, entanglement and superposition, thus enabling quantum computation. In alternative embodiments (not shown), a plurality of respective superconducting qubits is comprised in the integrated circuit 2, such as five respective qubits.

Notably, the superconducting qubit 30 comprises a Josephson junction 38 between the layers of high-critical-temperature superconductor material 36. This is a major difference over conventional hybrid quantum computers, which typically use a Josephson junction between low-temperature superconductor materials, such as elemental superconductor materials or superconductor materials with an isotropic (e.g., cubic) crystallographic structure.

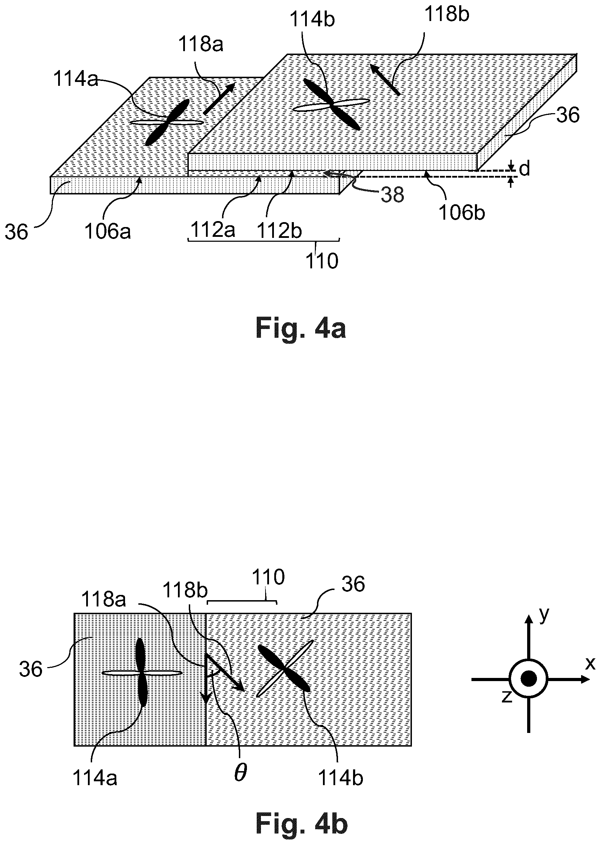

As is laid out in detail in the context of Fig. 4a, Fig. 4b, the use of high-critical-temperature superconductor material 36 significantly enhances the coherence time of the superconducting qubit 30. Moreover, because of the use of high-critical-temperature superconductor material, the superconducting qubit 30 is operable at higher temperatures, relaxing the need for cooling and thermal insulation. This is particularly beneficial in the context of the integrated circuit 2 according to the invention, wherein a semiconductor layer 10 with a transistor causing waste heat during operation is located in the vicinity of the superconducting qubit 30.

In the depicted embodiment, the high-critical-temperature superconductor material is BSCCO. However, in alternative embodiments, an alternative cuprate or an iron based high temperature superconductors (e.g., FeSe, potassium doped FeSe, FeSexTe1-x) is applied as the high-critical-temperature superconductor material.

In the depicted embodiment, the dielectric layer 20 is a silicon oxide layer with a thickness of 500 micrometres. In alternative embodiments, the dielectric layer 20 is made from a high-k dielectric such as silicon nitride, aluminum oxide, tantalum oxide, titanium oxide, strontium titanium oxide, zirconium oxide, hafnium oxide, hafnium silicon oxide, lanthanum oxide, yttrium oxide or lanthanum aluminum oxide.

According to some embodiments (not shown), the dielectric layer 20 has a substructure of several dielectric layers 20, or the dielectric layer 20 comprises several dielectric layers, respectively. In an exemplary embodiment, the dielectric layer 20 comprises a silicon nitride layer over the semiconductor layer 20 and a high-k dielectric layer with a static dielectric constant larger than the one of silicon nitride over the silicon nitride. This has the advantage of effective passivation and protection of the semiconductor layer 10 by the silicon nitride layer, and enhancement of the coherence time of the superconducting qubit 30 arranged on the high-k dielectric layer with the static dielectric constant larger than the one of silicon nitride.

In other words, the term dielectric layer 20 in some embodiments has the meaning of at least one dielectric layer 20, in particular of a stack of dielectric layers 20.

In the depicted embodiment, the at least one electrical component 50 coupling the superconducting qubit 30 to the transistor 12 is an electrical line through the dielectric layer 20 and for the silicon nitride layer 34.

In alternative embodiments (not shown) the at least one electrical component 50 coupling the superconducting qubit 30 to the transistor 12 passes only through one of the dielectric layer 20 and the silicon nitride layer 34, as shown, for example in Fig. 2. In yet alternative embodiments (not shown) the at least one electrical component 50 coupling the superconducting qubit 30 to the transistor 12 passes around both the dielectric layer 20 and the silicon nitride layer 34.

Although in the depicted embodiment an electrical line is shown as the electrical component 50 coupling the superconducting qubit 30 to the transistor 12, in alternative embodiments, other electrical components 50 are used, as will be prescribed in detail later. In particular, embodiments are preferred wherein the electrical component 50 comprises a coupling capacitor, providing an efficient coupling between the superconducting qubit 30 and the transistor 12. In some cases, an electrical component 50 comprising a microwave resonator may be preferred, in particular, as the microwave resonator provides an established, robust coupling to a superconducting qubit 30.

In some embodiments, the electrical component 50 coupling the superconducting qubit 30 to the transistor 12 comprises or is composed of a superconductor material. In particular, a respective material composition of the electrical component 50 is preferable in cases where the electrical component 50 comprises or is an electrical line or a coupling capacitor, as it reduces the resistance of the electrical component 50 at low temperature, thus improving the coherence time of the superconducting qubit 30.

Fig. 2 shows an embodiment of an integrated circuit 2 similar to the embodiment of Fig. 1. Similar elements are indicated by same reference numerals. For the sake of brevity and to avoid repetition, they will not be described again, but reference is made to the respective description above. In the following, the description of Fig. 2 will be limited to the differences to the foregoing embodiment.

Unlike in the embodiment of Fig. 1, wherein the capacitor 32 is arranged over the silicon nitride layer 34 arranged over the layers of high-critical-temperature superconductor material 36, in the embodiment of Fig. 2, the layers of high-critical-temperature superconductor material 36 are arranged over the silicon nitride layer 34 arranged over the capacitor 32.

In some instances, the arrangement of Fig. 1 is beneficial, as it ensures the formation of an encapsulation of the Josephson junction 38, or of the high-critical-temperature superconductor material 36 by the silicon nitride layer 34 and the dielectric layer 20 in a process step of placing the silicon nitride layer 34 over the dielectric layer 20. Respective embodiments reduce the number of process steps for fabricating the integrated circuit 2.

As can be seen from Fig. 2, an encapsulation of the Josephson junction 38, or of the high-critical-temperature superconductor material 36 between the silicon nitride layer 34 and the dielectric layer 20 can also be achieved in the embodiment of Fig. 2. In this case, material of the dielectric layer 20 is deposited over the Josephson junction 38, or over the high-critical-temperature superconductor material 36, respectively, to form said encapsulation.

As can be seen from the comparison of Fig. 1 and Fig. 2, the dielectric layer 20 being arranged between the semiconductor layer 10 and the superconducting qubit 30 does not require that the entire dielectric layer 20 is arranged between the semiconductor layer 10 and the superconducting qubit 30. Instead, at least a portion of the dielectric layer 20 is arranged between the semiconductor layer 10 and the superconducting qubit 30. Another portion of the dielectric layer, in some embodiments, is arranged to the side of the semiconductor layer 10 and/or to the side of the superconducting qubit 30, and/or above the superconducting qubit 30.

In alternative embodiments (not shown) a portion of the dielectric layer is arranged below the semiconductor layer 10.

Also shown in Fig. 2 is a vertical reference line v intersecting both the dielectric layer 20 and the transistor 12. Respective embodiments secure an efficient use of the lateral space available for the semiconductor components and the superconducting qubit. The vertical reference line v does not add any physical structure, but serves as a reference. In alternative embodiments (not shown), a respective vertical reference line does not exist.

In the depicted embodiment, the vertical reference line v intersects both the transistor 12 and the superconducting qubit 30, in particular, the capacitor 32. This further improves the use of the lateral space available for the semiconductor components of the superconducting qubit. In alternative embodiments (not shown), a respective vertical reference line does not exist.

Also shown in Fig. 2 is an axis c. This axis c exists in embodiments wherein the layer of the high-critical-temperature superconductor material 36 is a layer of an anisotropic, crystallographically layered material 36. In other words, the axis c exists in embodiments wherein the high-critical-temperature superconductor material is an anisotropic, crystallographically layered material. The axis c, per definition, is perpendicular to the covalently bound atomic layers 62 of the anisotropic, crystallographically layered material, as illustrated in detail in the context of Fig. 3.

As can be seen from Fig. 2, the axes c of the layers of anisotropic, crystallographically layered material 36, or the axes c of the respective anisotropic, crystallographically layered materials 36, respectively, are oriented along the vertical direction. In respective embodiments, the covalently bound atomic layers 62 of the anisotropic, crystallographically layered material 36 extend along the horizontal direction.

A respective arrangement implements a Josephson junction with a particularly long coherence time, as described in detail in EP 4 075 481 A1. This is beneficial for the operation of the integrated circuit 2 as a hybrid quantum computer.

Fig. 3 gives a closeup of the layer of the high-critical-temperature superconductor material 36, in an embodiment, wherein the high-critical-temperature superconductor material is an anisotropic, crystallographically layered material.

Shown in Fig. 3 is a close-up of one the layers of the high-critical-temperature superconductor material 36. The description given in this context applies correspondingly to the other one of the layers of the high-critical-temperature superconductor material 36.

A distance between the covalently bound atomic layers 62 of the anisotropic, crystallographically layered material is in the range from 1 to 5 nm, depending on the specific anisotropic, crystallographically layered material.

The covalently bound atomic layers 62 are separated from each other by van der Waals gaps 64.

The axis c is perpendicular to the covalently bound atomic layers 62, or to the van der Waals gaps 64, respectively.

Examples for respective anisotropic, crystallographically layered material are cuprates such as BSCCO (i.e., Bi₂Sr₂Caₙ₋₁CuₙO₂ₙ₊₄₊ₓ where n = 2, 3, 4), or iron based high temperature superconductors (e.g., FeSe, potassium doped FeSe, FeSexTe1-x).

Fig. 4a, Fig. 4b illustrate, in detail, the layers of high-critical-temperature superconductor material 36 forming the Josephson junction 38. More specifically, the layers of high-critical-temperature superconductor material 36 are arranged above one another in a region 110 to form the Josephson junction 38.

Fig. 4a gives a perspective view of the layers of high-critical-temperature superconductor material 36 and of the Josephson junction 38, whereas Fig. 4b gives a top view. The detailed description of layers of high-critical-temperature superconductor material 36 and the Josephson junction 38 of Fig. 4a, Fig. 4b applies as well to the layers of high-critical-temperature superconductor material 36 and the Josephson junction 38 of the integrated circuit 2 according to any of the various embodiments described in this disclosure.

The layers of high-critical-temperature superconductor material 36 overlap in the region 110. In other words, the region 110 forms an overlap region 110 (i.e., of the layers of high-critical-temperature superconductor material 36). More specifically, in the overlap region 110, a first section 112a of a first surface 106a of one of the layers of high-critical-temperature superconductor material 36 faces a second section 112b of a second surface 106b of another one of the layers of high-critical-temperature superconductor material 36, and vice versa.

The layers of high-critical-temperature superconductor material 36 are separated by a distance d, specifically, in the overlap region 110.

The first high-critical-temperature superconductor material, i.e., the high-critical-temperature superconductor material of the first one of the layers of high-critical-temperature superconductor material 36, has a first orientation 118a. In Fig. 4a, Fig. 4b, the first orientation 118a is represented by an arrow 118a in a horizontal plane. In other words, the first orientation 118a is parallel to the first section 112a of the first surface 106a.

The second high-critical-temperature superconductor material, i.e., the high-critical-temperature superconductor material of the other one of the layers of high-critical-temperature superconductor material 36, has a corresponding second orientation 118b.

The orientations 118a, 118b can be defined by any or any combination of the following criteria, wherein the first/second high-critical-temperature superconductor material refer to the high-critical-temperature superconductor material of the first/second layer of high-critical-temperature superconductor material:

According to a first definition, the orientations 118a, 118b correspond to primitive lattice vectors of the first/second high-critical-temperature superconductor material, such as respective in-plane primitive lattice vectors, or to projections of primitive lattice vectors of the respective (first/second) superconductor materials onto a horizontal plane, or onto the first surface 106a, or onto the second surface 106b, respectively.

Alternatively, the orientations 118a, 118b are defined by crystal facets of the first/second high-critical-temperature superconductor material.

The orientations 118a, 118b are alternatively defined by reciprocal lattice vectors of the first/second high-critical-temperature superconductor material, i.e., by in plane reciprocal lattice vectors or by projections of the reciprocal lattice vectors onto a horizontal plane, or onto the first surface 106a, or onto the second surface 106b, respectively.

Alternatively, the orientations 118a, 118b are defined by electronic orbitals 114a, 114b or by crystal momenta of a Bloch state of the first/second high-critical-temperature superconductor material. According to some embodiments, the first/second high-critical-temperature superconductor material is a d-wave superconductor, or a superconductor with a d-wave superconducting gap, respectively. In this case, the orientation 118a, 118b may be associated with a d-wave electronic spectrum, in particular with a d-wave nodal electronic spectrum 114a.

The first orientation 118a and the second orientation 118b are arranged at an angle θ, according to a predefined angle.

In particular, when the angle θ is in the range from 38 to 44.9°, the single-Cooper pair tunneling *E_{J},* or the Josephson energy, *E_{J},* respectively, is suppressed. The inventors have verified the finding of a suppressed Josephson energy E_{J} using simulations for BSCCO, and more specifically for Bi₂Sr₂CaCu₂O₈₊ₓ. It is similarly expected for other d-wave superconductors (or high-critical-temperature superconductor materials, respectively, or superconductors comprising anisotropic, layered superconductor material, respectively) with an angle of approximately 90° between their primitive lattice vectors perpendicular to the axis c.

The Josephson energy is directly related to the critical current *I_{c}* of the Josephson junction 38 as *E_{J} = I_{c}*Φ₀/*2π* where Φ₀ *= h*/*2e* is the flux quantum.

In this situation, two-Cooper pair tunneling is still possible, and the two-Cooper pair tunneling energy *Eₖ* is similar to the Josephson energy, E_{J}. The two-Cooper pair tunneling term can be written as *E_{κ}*cos (2*ϕ*), forming a double-well potential. In preferred embodiments, the corresponding two lowest-energy eigenstates are used to provide the two-level system of the superconducting qubit 30. The energy difference between the respective eigenstates of the two-level is small, i.e., within an energy/frequency difference of up to 2 GHz, and in some embodiments up to 1 GHz. The respective eigenstates are therefore referred to as quasi-degenerate.

The degeneracy goes hand in hand with, and therefore indicates a situation in which dielectric losses and crosstalk between qubit devices (i.e., between the quantum-mechanical states of their respective two-level systems) are drastically reduced. Those dielectric losses and crosstalk are the main limitations of conventional transmon qubits. Thus, the relaxation time of the described superconducting qubit 30 is improved significantly as compared to the relaxation time in a conventional qubit device, e.g., of the transmon type. According to simulations performed by the inventors, the improvement amounts to a factor of 10.000, leading to coherence times up to 1 s.

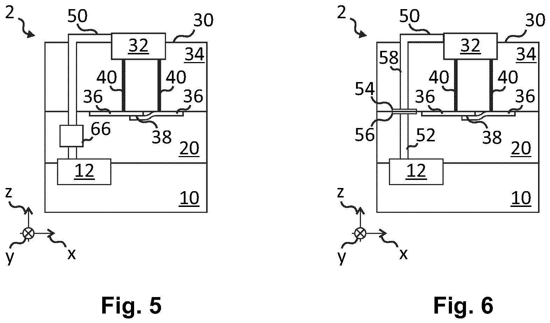

Fig. 5 shows an embodiment of an integrated circuit 2 similar to the embodiments of Fig. 1 and Fig. 2. Similar elements are indicated by same reference numerals. For the sake of brevity and to avoid repetition, they will not be described again, but reference is made to the respective description above. In the following, the description of Fig. 5 will be limited to the differences to the foregoing embodiments.

In the embodiment of Fig. 5, the at least one electrical component 50 coupling the superconducting qubit 30 to the transistor 12 comprises a coupling capacitor 66. In other words, the superconducting qubit 30 is capacitively coupled to the transistor 12.

The capacitive coupling, or the coupling capacitor 66, respectively, provides an efficient and low latency coupling between the semiconductor layer 10 and the superconducting qubit 30.

Preferably, the coupling capacitor 66 has a negative capacitance.

For this purpose, the coupling capacitor comprises a first coupling capacitor electrode, a second coupling capacitor electrode, and a ferroelectric structure arranged between the first coupling capacitor electrode and the second coupling capacitor electrode.

To ensure a stable negative capacitance, according to some embodiments, the ferroelectric structure comprises a plurality of ferroelectric polarization domains and at least one ferroelectric domain wall.

In some embodiments, the ferroelectric structure arranged between the first coupling capacitor electrode and the second coupling capacitor electrode has a cross-sectional area with an orientation corresponding to an orientation of a surface of the first or second coupling capacitor electrode facing the ferroelectric structure. The cross-sectional area defines a shortest separation line to divide the cross sectional-area into a plurality of regions of essentially equal area, in particular into two regions of essentially equal area. A reference line is shifted with respect to said shortest separation line and in a surface defined by the cross-sectional area. A length of the reference line within the cross-sectional area is shorter than a length of the shortest separation line within the cross-sectional area by a difference which increases with increasing distance between the reference line and the shortest separation line in a vicinity of the shortest separation line. This ensures suitable ferroelectric polarization domains and a suitable at least one ferroelectric domain wall for the coupling capacitor to provide a stable negative capacitance, as described in detail in EP 4 075 481 A1.

In the depicted embodiment, the coupling capacitor 66 is arranged in the dielectric layer 20. In alternative embodiments (not shown) the coupling capacitor 66 is comprised in the semiconductor layer 10. In alternative embodiments (not shown) the coupling capacitor 66 is comprised in the superconducting qubit 30, in particular, arranged at least in part in and/or on the silicon nitride layer 34.

The capacitive coupling, or the coupling capacitor 66, respectively, have been described in the context of the embodiment of Fig. 5. However, the capacitive coupling, or the coupling capacitor 66, respectively, is not limited to that embodiment. Preferably, the at least one electrical component coupling the superconducting qubit to the transistor of any of the embodiments of Fig. 1, Fig. 2, Fig. 6, Fig. 7a and Fig. 7b, Fig. 8, Fig. 9, Fig. 11 or Fig. 12 couples the superconducting qubit to the transistor capacitively, or comprises the coupling capacitor 66, respectively.

Fig. 6 shows an embodiment of an integrated circuit 2 similar to the foregoing embodiments. Similar elements are indicated by same reference numerals. For the sake of brevity and to avoid repetition, they will not be described again, but reference is made to the respective description above. In the following, the description of Fig. 6 will be limited to the differences to the foregoing embodiments.

In the embodiment of Fig. 6, the at least one electrical component 50 coupling the superconducting qubit 30 to the transistor 12 comprises a first bond pad 54 and a second bond pad 56.

The first bond pad 54 is electrically coupled to the second bond pad 56.

The first bond pad 54 is arranged on the silicon nitride layer 34. The second bond pad 56 is on the dielectric layer 20.

The at least one electrical component 50 coupling the superconducting qubit 30 to the transistor 12 further comprises the electrically conductive lines 52, 58.

In the fabrication of the integrated circuit 2, the first bond pads 54 are provided with the silicon nitride layer 34, and the second bond pads 56 are provided with the dielectric layer 20. The first and second bond pads 54, 56 thus ensure a reliable connection via the at least one electrical component 50 from one of the respective layers 34, 20, 10 to the other during the assembly of the integrated circuit 2.

The first and second bond pads 54, 56 have been described in the context of the embodiment of Fig. 6. However, the first and second bond pads 54, 56 are not limited to that embodiment. Preferably, the at least one electrical component 50 coupling the superconducting qubit to the transistor of any of the embodiments of Fig. 1, Fig. 2, Fig. 5, Fig. 7a and Fig. 7b, Fig. 8, Fig. 9, Fig. 10, Fig. 11 or Fig. 12 comprises the first and second bond pads 54, 56.

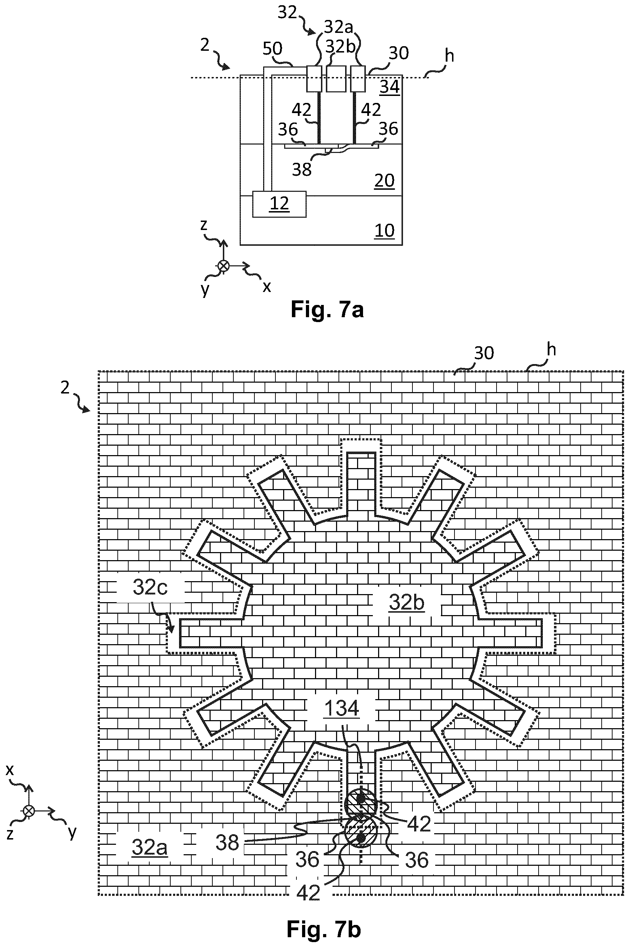

Fig. 7a, Fig. 7b show an embodiment of an integrated circuit 2 similar to the foregoing embodiments. Similar elements are indicated by same reference numerals. For the sake of brevity and to avoid repetition, they will not be described again, but reference is made to the respective description above. In the following, the description of Fig. 7a, Fig. 7b will be limited to the differences to the foregoing embodiments.

Fig. 7a gives a cross-sectional view of the integrated circuit 2, and Fig. 7b gives a top view thereof.

As is shown in Fig. 7a, Fig. 7b, the capacitor 32 comprises a first electrode 32a and a second electrode 32b. The electrodes 32a, 32b are spaced apart by a gap 32c.

As is shown in Fig. 7a, Fig. 7b, the capacitor 32 is a planar capacitor 32. In other words, a horizontal reference plane h intersects both the first electrode 32a and the second electrode 32b. In yet other words, the first electrode 32a and the second electrode 32b extend along said horizontal reference plane h.

The first electrode 32a encircles the second electrode 32b, more specifically, in the horizontal reference plane h.

The planar capacitor 32 is arranged on the silicon nitride layer 34.

A capacitance of the capacitor 32 in a range from 70 to 400 femtofarads has proven beneficial.

The resulting capacitive energy *E_{c} = e²*/*2C,* where e is the electron charge, is smaller than the typical Josephson energy, *E_{J},* of the Josephson junction 38 by a factor of 100 or more.

The planar capacitor 32 has been described in the context of the embodiment of Fig. 7a, Fig. 7b. However, the planar capacitor 32 is not limited to that embodiment. Preferably, the integrated circuit 2 of any of the embodiments of Fig. 1, Fig. 2, Fig. 5, Fig. 6, Fig. 8, Fig. 9, Fig. 10, Fig. 11 or Fig. 12 comprises a planar capacitor 32.

Also shown in Fig. 7a, Fig. 7b are a interconnects 42, i.e., first and second interconnects 42. A first one of the interconnects 42 is connected to the first electrode 32a of the capacitor 32. A second one of the interconnects 42 is connected to the second electrode 32b of the capacitor 32.

The first interconnect 42 electrically connects the first electrode 32a and a first one of the layers of high-critical-temperature superconductor material 36. The second interconnect 42 electrically connects the second electrode 32b and a second one of the layers of high-critical-temperature superconductor material 36.

The first and second interconnect 42 are preferably provided in a fabrication process together with the silicon nitride layer 34, initially separate from the semiconductor layer 10 and from the transistor 12. Since, in the respective embodiments, the interconnects 42 are aligned with respect to the silicon nitride layer 34, respective embodiments allow for a particularly reliable assembly of the integrated circuit 2.

In the depicted embodiment, the first interconnect 42 and the second interconnect 42 are vertical interconnects 42. This improves the usage of the lateral space available for the integrated circuit 2. Although less preferable, any of the interconnects 42 may, however, have a different shape and extend, for example, around the silicon nitride layer 34.

The interconnects 42 have been described in the context of the embodiment of Fig. 7a, Fig. 7b. However, the interconnects 42 are not limited to that embodiment. Preferably, the integrated circuit 2 of any of the embodiments of Fig. 1, Fig. 2, Fig. 5, Fig. 6, Fig. 8, Fig. 9, Fig. 10, Fig. 11 or Fig. 12 comprises interconnects 42.

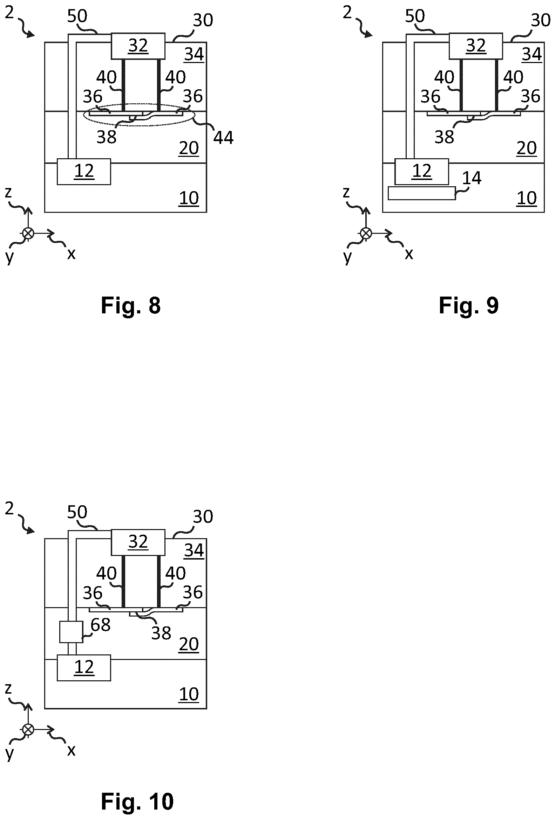

Fig. 8 shows an embodiment of an integrated circuit 2 similar to the foregoing embodiments. Similar elements are indicated by same reference numerals. For the sake of brevity and to avoid repetition, they will not be described again, but reference is made to the respective description above. In the following, the description of Fig. 8 will be limited aspects of particular relevance to this embodiment.

The integrated circuit 2 according to the embodiment of Fig. 8 comprises an encapsulation 44 to the Josephson junction. The encapsulation 44 shown in Fig. 8 also encapsulates the layers of high-critical-temperature superconductor material 36 forming the Josephson junction 38. However, this is not necessarily the case, and in alternative embodiments (not shown), the encapsulation 44 encapsulates an overlap region 110 of the layers of high-critical-temperature superconductor material 36, without necessarily encapsulating the entire layers of high-critical-temperature superconductor material 36.

Preferably, the encapsulation 44 is watertight and moisture tight. Even more preferably, it is also airtight.

Said encapsulation thus prevents chemical reactions on the layers of high-critical-temperature superconductor material 36 forming the Josephson junction 38. This is particularly important for the superconducting qubit 30 according to this disclosure, since the applied high-critical-temperature superconductor material(s) is or are typically highly sensitive to water and moisture. Depending on the specific high-critical-temperature superconductor material(s), it may also be sensitive to oxygen. The encapsulation thus reduces and ideally prevents chemical reactions of layer of the high-critical-temperature superconductor material 36 forming the Josephson junction 38 which would otherwise affect the performance of the Josephson junction 38.

In the depicted embodiment, the encapsulation is formed in part by the silicon nitride layer 34 and in part by the dielectric layer 20.

The encapsulation 44 has been described in the context of the embodiment of Fig. 8. However, the encapsulation 44 is not limited to that embodiment. Preferably, the integrated circuit 2 of any of the embodiments of Fig. 1, Fig. 2, Fig. 5, Fig. 6, Fig. 7a and Fig. 7b, Fig. 9, Fig. 10, Fig. 11 or Fig. 12 comprises the encapsulation 44.

Fig. 9 shows an embodiment of an integrated circuit 2 similar to the foregoing embodiments. Similar elements are indicated by same reference numerals. For the sake of brevity and to avoid repetition, they will not be described again, but reference is made to the respective description above. In the following, the description of Fig. 9 will be limited to the differences to the foregoing embodiments.

The integrated circuit 2 according to the embodiment of Fig. 9 comprises a heating element 14 in the semiconductor layer 10. The heating element 14 is designed to provide heat to the transistor 12, ensuring optimal operating conditions.

In the depicted embodiment, the heating element 14 is a resistive heater 14, or the heating element 14 comprises a resistor, respectively.

The heating element 14 is made of a resistive material such as polysilicon or a metal or a metal alloy, such as tungsten or nichrome, and it is integrated into the semiconductor layer 10 using standard semiconductor fabrication techniques.

According to different embodiments, heating element 14 is implemented using different geometries such as serpentine or spiral patterns.

The heating element 14 ensures that the transistor 12 operates within its optimal temperature range, which is beneficial for maintaining the performance and reliability of the integrated circuit. In particular, if the cooling of the superconducting qubit 30 results in a temperature at the transistor 12 outside of the working conditions of the transistor 12, the heating element 14 is operated (i.e., current is sent through the heating element 14 in embodiments wherein the heating element 14 is a resistive heater 14) to provide heat to the transistor 12.

The heating element 14 has been described in the context of the embodiment of Fig. 9. However, the heating element 14 is not limited to that embodiment. Preferably, the integrated circuit 2 of any of the embodiments of Fig. 1, Fig. 2, Fig. 5, Fig. 6, Fig. 7a and Fig. 7b, Fig. 8, Fig. 10, Fig. 11 or Fig. 12 comprises the heating element 14.

Fig. 10 shows an embodiment of an integrated circuit 2 similar to the foregoing embodiments. Similar elements are indicated by same reference numerals. For the sake of brevity and to avoid repetition, they will not be described again, but reference is made to the respective description above. In the following, the description of Fig. 10 will be limited to the differences to the foregoing embodiments.

In the embodiment of Fig. 10, the at least one electrical component 50 coupling the superconducting qubit 30 to the transistor 12 comprises a microwave resonator 68.

In the depicted embodiment, the microwave resonator 68 is a superconducting coplanar waveguide or a microstrip resonator, designed to facilitate the interaction between the superconducting qubit 30 and the transistor 12. The microwave resonator 68 is fabricated using standard lithographic techniques on a superconducting material such as niobium or aluminum.

According to alternative embodiments (not shown), the microwave resonator 68 is implemented using different resonator types such as lumped element resonators or dielectric resonators.

The microwave resonator 68 is a well-established way to enable efficient coupling between the superconducting qubit 30 and the transistor 12. Generally, the use of capacitive coupling, or of coupling capacitor 66, respectively, as described in the context of the embodiment of Fig. 5, is preferred for the at least one electrical component 50 coupling the superconducting qubit 30 to the transistor 12. This is because the use of a capacitive coupling, or of the coupling capacitor 66, respectively provides a reduced latency over microwave generation, transmission, reception and detection. However, the use of the microwave resonator 68 may be beneficial in use cases where latency is less critical.

The microwave resonator 68 has been described in the context of the embodiment of Fig. 10. However, the microwave resonator 68 is not limited to that embodiment. The integrated circuit 2 of any of the embodiments of Fig. 1, Fig. 2, Fig. 6, Fig. 7a and Fig. 7b, Fig. 8, Fig. 9, Fig. 11 or Fig. 12 is optionally formed with the microwave resonator 68.

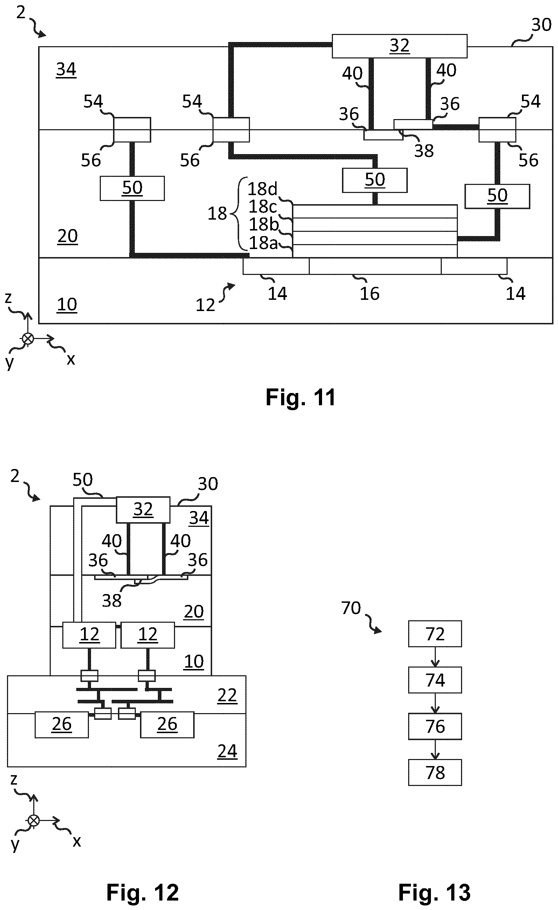

Fig. 11 shows an embodiment of an integrated circuit 2 similar to the foregoing embodiments. Similar elements are indicated by same reference numerals. For the sake of brevity and to avoid repetition, they will not be described again, but reference is made to the respective description above. In the following, the description of Fig. 11 will be limited to the differences to the foregoing embodiments.

In the embodiment of Fig. 11, the transistor 12 is illustrated in further detail.

The transistor 12 comprises source-/drain regions 14.

The transistor 12 comprises a channel 16. In the depicted embodiment, the channel 16 extends from one of the source-/drain regions 14 to another one of the source-/drain regions 14.

The transistor 12 comprises a gate structure 18. The gate structure 18 is arranged over the channel 16.

The gate structure 18 comprises a gate dielectric 18a and a gate electrode 18d.

In the depicted embodiment, the gate structure 18 further comprises an intermediate electrode 18b and a gate ferroelectric 18c.

However, in alternative embodiments (not shown), the intermediate electrode 18b and the gate ferroelectric 18c are not present. In respective embodiments, the gate electrode 18d is arranged over the gate dielectric 18a, for example directly over the gate dielectric 18a.

In the depicted embodiment, the intermediate electrode 18b, the gate electrode 18d, and the gate ferroelectric 18c form a gate capacitor having a negative capacitance, preferably a stable negative capacitance. This is achieved by forming the intermediate electrode 18b, the gate electrode 18d and the gate ferroelectric 18c similar to the first coupling capacitor electrode, to the second coupling capacitor electrode, and to the ferroelectric structure arranged between the first coupling capacitor electrode and the second coupling capacitor electrode. For further details regarding the intermediate electrode 18b, the gate electrode 18d, and the gate ferroelectric 18c, reference is thus made to the corresponding description of the first coupling capacitor electrode, the second coupling capacitor electrode, and the ferroelectric structure arranged between the first coupling capacitor electrode and the second coupling capacitor electrode given above in the context of Fig. 5, which applies correspondingly to the intermediate electrode 18b, the gate electrode 18d, and the gate ferroelectric 18c.

in embodiments with the intermediate electrode 18b, the gate electrode 18d, and the gate ferroelectric 18c forming the gate capacitor having the negative capacitance, the transistor 12 is referred to as a negative-capacitance transistor 12.

In respective embodiments, the gate dielectric 18a is typically non-ferroelectric. Preferably, the gate dielectric 18a comprises a high-k dielectric material.

Providing the integrated circuit 2 with a negative-capacitance transistor 12 improves the power efficiency and operational speed of the integrated circuit 2, in particular, as it allows for the usage of a reduced operating voltage of the integrated circuit 2.

The negative-capacitance transistor 12 has been described in the context of the embodiment of Fig. 11. However, the negative-capacitance transistor 12 is not limited to that embodiment. The integrated circuit 2 of any of the embodiments of Fig. 1, Fig. 2, Fig. 5, Fig. 6, Fig. 7a and Fig. 7b, Fig. 8, Fig. 9, Fig. 10 or Fig. 12 is preferably formed with the negative-capacitance transistor 12.

In the depicted embodiment, the transistor 12 is coupled to the superconducting qubit 30 through the intermediate electrode 18b, the gate electrode 18d, and the gate ferroelectric 18c providing the gate capacitor having the negative capacitance. The integrated circuit 2 according to the embodiment of Fig. 11 thus provides the advantages described above in the context of the coupling capacitor 66 of Fig. 5 having the negative capacitance.

In the depicted embodiment, the transistor 12 is coupled to the first electrode 32a of the capacitor 32 of the superconducting qubit 30 through the gate structure 18. A respective arrangement is not limited to the embodiment of Fig. 11, but is preferably also employed in the integrated circuit according to any of the other embodiments.

In the depicted embodiment, the transistor 12 is coupled to the Josephson junction 38 of the superconducting qubit 30 through the intermediate electrode 18b. A respective arrangement is not limited to the embodiment of Fig. 11, but is preferably also employed in the integrated circuit according to any of the other embodiments.

In Fig. 11, both the coupling of the transistor 12 to the first electrode 32a of the capacitor 32 of the superconducting qubit 30 through the gate structure 18 and the coupling of the transistor 12 to the Josephson junction 38 of the superconducting qubit 30 through the intermediate electrode 18b are depicted. In alternative embodiments (not shown), only one of the respective couplings is present. This applies not only to the embodiment of Fig. 11, but also to the integrated circuit according to any of the other embodiments.

Fig. 12 shows an embodiment of an integrated circuit 2 similar to the foregoing embodiments. Similar elements are indicated by same reference numerals. For the sake of brevity and to avoid repetition, they will not be described again, but reference is made to the respective description above. In the following, the description of Fig. 12 will be limited to the differences to the foregoing embodiments.

The integrated circuit 2 according to the embodiment of Fig. 12 comprises an additional semiconductor layer 24. The superconducting qubit 30 is arranged to a first side of the semiconductor layer 10, and the additional semiconductor layer 24 is arranged to a second side of the semiconductor layer 10 opposite to the first side. In the specific depicted embodiment, the additional semiconductor layer 24 is arranged below the semiconductor layer 10.

The additional semiconductor layer 24 according to some embodiments serves as a substrate 24 to mechanically support the semiconductor layer 10 as well as the dielectric layer 20 and the superconducting qubit 30 arranged thereon.

According to some embodiments, the additional semiconductor layer 24 comprises electrical support lines for power-supplying the semiconductor layer 10. The respective electrical support lines are larger in cross section than any of the electrical connections described above in the context of the electrical coupling elements 40 or the interconnects 42.

In respective embodiments, the additional semiconductor layer 24 optionally comprises transistors 26 for controlling said power supply.

An optional redistribution layer 22 is arranged between the semiconductor layer 10 and the additional semiconductor layer 24.

The redistribution layer 22 distributes the power supply from the additional semiconductor layer 24 onto the semiconductor layer 10.

The additional semiconductor layer 24 and the optional redistribution layer 22 have been described in the context of the embodiment of Fig. 12. However, the additional semiconductor layer 24 and the optional redistribution layer 22 are not limited to that embodiment. The integrated circuit 2 of any of the embodiments of Fig. 1, Fig. 2, Fig. 5, Fig. 6, Fig. 7a and Fig. 7b, Fig. 8, Fig. 9, Fig. 10 or Fig. 12 is preferably formed with the additional semiconductor layer 24 and the optional redistribution layer 22.

Fig. 13 illustrates a method 70 for fabricating an integrated circuit 2. The method includes the following steps: providing a semiconductor layer 10 and a dielectric layer 20 over the semiconductor layer 10 (step 72), providing a capacitor layer 130 separate from the semiconductor layer 10 and dielectric layer 20 (step 74), providing layers of high-critical-temperature superconductor material 36 forming a Josephson junction 38 between them (step 76), and arranging the capacitor layer 130 and the layers of high-critical-temperature superconductor material 36 over the semiconductor layer 10 and dielectric layer 20 (step 78).

Step 72 involves providing the semiconductor layer 10, which includes a transistor 12, and the dielectric layer 20, which is arranged above the semiconductor layer 10.

Step 74 entails providing the capacitor layer 130 separate from the semiconductor layer 10, the capacitor layer 130 comprising a silicon nitride layer 34, a capacitor 32, and electrical coupling elements 40. The capacitor 32 includes first and second electrodes. The electrical coupling elements 40 comprise a first electrical coupling element in electrical contact with the first electrode 32a and a second electrical coupling element in electrical contact with the second electrode 32b.

Step 76 involves providing the layers of high-critical-temperature superconductor material 36, which form a Josephson junction 38 between them.

Step 78 includes arranging the capacitor layer 130 and the layers of high-critical-temperature superconductor material 36 over the semiconductor layer 10 and dielectric layer 20. The capacitor 32, silicon nitride layer 34, and layers of high-critical-temperature superconductor material 36 form the superconducting qubit 30, with the dielectric layer 20 arranged between the semiconductor layer 10 and the superconducting qubit 30. In the superconducting qubit 30 the Josephson junction 38 is electrically coupled to the capacitor 32 through the first electrical coupling element and the second electrical coupling element and at least a section of the silicon nitride layer 34 is arranged between the capacitor 32 and the Josephson junction 38.

According to alternative embodiments (not shown), the method may include additional steps or variations in the sequence of operations. The semiconductor layer 10 and dielectric layer 20 may be provided in different configurations, and the capacitor layer 130 may include various types of capacitors and electrical coupling elements.

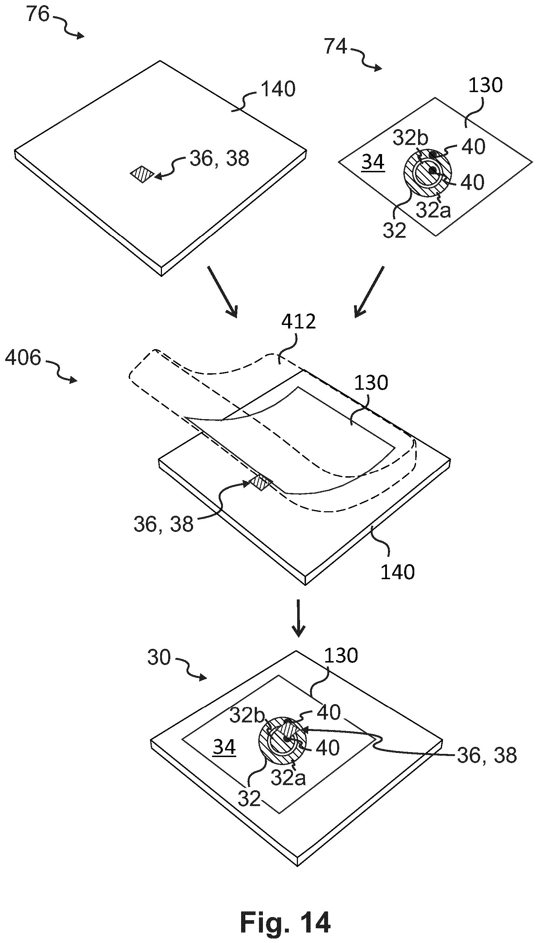

Fig. 14 illustrates process steps 74, 76 and 78 in further detail.

At step 76, the layers of high-critical-temperature superconductor material 36 are provided, forming the Josephson junction 38 between them. In Fig. 14, the layers of high-critical-temperature superconductor material 36 and the Josephson junction 38 are not individual resolved, but are indicated as a single structure. Regarding their detailed description, reference is made to the description of the layers of high-critical-temperature superconductor material 36 and the Josephson junction 38 in the context of the integrated circuit 2 according to the embodiments of Fig. 1 to Fig. 12. This description applies correspondingly to the high-critical-temperature superconductor material 36 and the Josephson junction 38 of the method 70.

A detailed description of an example how to provide the layers of high-critical-temperature superconductor material 36 forming the Josephson junction 38 between them is given EP 4270504 A1. EP 4270504 A1 is incorporated herein in its entirety by reference.

In step 76 of Fig. 14, the layers of high-critical-temperature superconductor material 36 forming the Josephson junction 38 between them are provided over a second substrate 140.

According to some embodiments, the second substrate 140 includes the semiconductor layer 10 and the dielectric layer 20 thereover. In respective embodiments, the layers of high-critical-temperature superconductor material 36 forming the Josephson junction 38 between them are placed over the dielectric layer 20 using the techniques described in detail in EP 4270504 A1. Respective embodiments minimize the number of process steps of the method 70, thus making it more reliable and economic.

According to alternative embodiments, the second substrate 140 does not comprise the semiconductor layer 10, but a different second substrate 140, such as a silicon oxide layer on silicon, is used.

At step 74, a capacitor layer 130 is provided separate from the layers of high-critical-temperature superconductor material 36 and from the Josephson junction 38.

The capacitor layer 130 comprises a silicon nitride layer 34.

The capacitor layer 130 further comprises a capacitor 32 over the silicon nitride layer 34. The capacitor 32 comprises a first electrode 32a and a second electrode 32b. In the depicted embodiment, the capacitor 32 is a planar capacitor 32 similar to the planar capacitor 32 described in the context of Fig. 7a, Fig. 7b.

The capacitor layer 130 further comprises electrical coupling elements 40. A first electrical coupling element of the electrical coupling elements 40 is in electrical contact with the first electrode 32a of the capacitor 32. A second electrical coupling element of the electrical coupling elements 40 is in electrical contact with the second electrode 32b of the capacitor 32.

In sum, preferred embodiments, the capacitor layer 130 further comprises first contact pads 54 (not shown) similar to the first contact pads 54 described above in the context of Fig. 6. In respective embodiments, the first electrical coupling element is electrically connected to a first one of the first contact pads 54, and the second electrical coupling element is electrically connected to a second one of the first contact pads 54.

Preferably, the capacitor 32 is arranged on a first side of the silicon nitride layer 34, and the first contact pads 54 are arranged on a second side of the silicon nitride layer 34 opposite to the first side. In alternative embodiments, the capacitor 32 and the first contact pads 54 are arranged on the same side of the silicon nitride layer 34.

The electrical coupling elements 40 extends through the silicon nitride layer 34 from the upper surface of the silicon nitride layer 34 with the capacitor thereon to the bottom surface of the silicon nitride layer 34. At the bottom surface of the silicon nitride layer 34, the electrical coupling elements 40 are exposed to connect to the layers of high-critical-temperature superconductor material 36in the subsequent process step 406.

In some embodiments (not shown), the capacitor layer 130 is provided with additional, optional electrical elements, such as with a coupling capacitor 66 or with a microwave resonator 68.

At step 406, the capacitor layer 130 is arranged over the layers of high-critical-temperature superconductor material 36 forming the Josephson junction 38 between them to form an electrical contact between the first electrical coupling element and a first one of the layers of high-critical-temperature superconductor material 36, and to form an electrical contact between the second electrical coupling element and a second one of the layers of high-critical-temperature superconductor material 36, the first one and the second one of the layers of high-critical-temperature superconductor material 36 forming the Josephson junction 38 between them.

In some embodiments, at step 406, the capacitor layer 130 is cooled with liquid-nitrogen to a temperature < -85°C (in other words, below a second temperature of -85°C) and is arranged over the Josephson junction 38 while being at said low temperature. For this purpose, the capacitor layer 130 is arranged on a PDMS stamp 412 serving as a transfer device 412. The capacitor layer 130 and the transfer device 412 are then cooled below the second temperature. Below the second temperature, the PDMS stamp 412 provides a strong adhesion to the capacitor layer 130, allowing to move the capacitor layer 130 adhering to the PDMS stamp 412.

Then, the PDMS stamp 412 and the capacitor layer 130 arranged thereon are positioned over and in physical contact with the substrate 140 and the layers of high-critical-temperature superconductor material 36 forming the Josephson junction 38 between them. Thereby, the capacitor layer 130 is arranged 406 over the Josephson junction 38.

In this process step, the PDMS stamp 412 and thus the capacitor layer 130 are aligned such that, when the capacitor layer 130 is brought into physical contact with the second substrate 140 and the layers of high-critical-temperature superconductor material 36, the exposed first and second coupling elements 40 each contact one of the layers of high-critical-temperature superconductor material 36 forming the Josephson junction 38 between them. For this purpose, the capacitor layer 130 and the substrate 140 are provided with optical markers indicating the position of the first and second coupling elements 40 and of the layers of high-critical-temperature superconductor material 36, respectively.

In an optional additional step, the PDMS stamp 412 is removed from the capacitor layer 130. For this purpose, the PDMS stamp 412 is heated to a temperature above the second temperature, and preferably to a temperature > -30°C. In other words, the PDMS stamp 412 is heated above the second temperature, and preferably above a third temperature of -30°C. This reduces the adhesion of the PDMS stamp 412. Consequently, the PDMS stamp may be removed, leaving the capacitor layer 130 arranged over the layers of high-critical-temperature superconductor material 36 forming the Josephson junction 38 between them.

To avoid thermal damage to the layers of high-critical-temperature superconductor material 36, the temperature of the layers of high-critical-temperature superconductor material 36 is kept below o°C (first temperature) while arranging the capacitor layer 130 thereover. This is achieved by keeping the temperature of the PDMS stamp 412 below the first temperature while the PDMS stamp 412 is in contact with the substrate 140 and/or with the layers of high-critical-temperature superconductor material 36 forming the Josephson junction 38 between them.

The reduced adhesion of the PDMS stamp 412 at elevated temperature (as compared to the second temperature of -85°C) is related to the amorphous molecular structure of the PDMS with a glass transition temperature of around -100°C. Consequently, the third temperature is above the glass transition temperature of the PDMS. The second temperature amounts to at least the glass transition temperature of the PDMS. For temperatures above the glass transition temperature, the adhesion of elastic polymers decreases with increasing temperature. In other words, an alternative material may be used for the transfer device 412 instead of PDMS, in particular an elastic polymer for as long as its glass transition temperature is below the second temperature (and the third temperature).

In embodiments, wherein the second substrate 140 includes the semiconductor layer 10 and the dielectric layer 20 thereover, the fabrication of the integrated circuit 2 is completed with arranging the capacitor layer 130 over the layers of high-critical-temperature superconductor material 36 forming the Josephson junction 38.

In respective embodiments, the PDMS stamp 412 and thus the capacitor layer 130 are aligned such that, when the capacitor layer 130 is brought into physical contact with the second substrate 140 and the layers of high-critical-temperature superconductor material 36, the first contact pad 54 contacts a second contact pad 56 on the dielectric layer 20. For this purpose, the capacitor layer 130 and the substrate 140 are provided with optical markers indicating the position of the first contact pad 54 and of the second contact pad 56, respectively.

In embodiments, wherein the second substrate 140 does not comprise the semiconductor layer 10, further process steps are required to lift up the layers of high-critical-temperature superconductor material 36 forming the Josephson junction 38 between them together with the capacitor layer 130. In respective embodiments, the respective lifting up of the layers of high-critical-temperature superconductor material 36 forming the Josephson junction 38 between them together with the capacitor layer 130 is achieved using a transfer device 412 as described in the context of the process step 406. In other words, the transfer device 412 is arranged over the capacitor layer 130 located over the layers of high-critical-temperature superconductor material 36 forming the Josephson junction 38 between them. The transfer device 412 is then cooled to a temperature below the second temperature, or to a temperature below the glass transition temperature of an elastomeric polymer comprised in the transfer device 412, respectively, to ensure a strong adhesion of the transfer device 412 to the capacitor layer 130 over the layers of high-critical-temperature superconductor material 36 forming the Josephson junction 38 between them. Then the transfer device 412 is lifted up, with the capacitor layer 130 and the layers of high-critical-temperature superconductor material 36 forming the Josephson junction 38 between them sticking to the transfer device 412 due to the strong adhesion. This way, the capacitor layer 130 and the layers of high-critical-temperature superconductor material 36 forming the Josephson junction 38 between them are are adhered to the transfer device 412, moved around with the transfer device 412, and this way they are transferred over the dielectric layer 20 over the semiconductor layer 10 and positioned thereover. Optionally, the transfer device 412 is heated, in particular to a temperature above the second temperature or, preferably, to a temperature above the third temperature, to reduce the adhesion of the transfer device 412 to the capacitor layer 130 and the layers of high-critical-temperature superconductor material 36 forming the Josephson junction 38 between them. The transfer device 412 is then optionally removed from the capacitor layer 130 and the layers of high-critical-temperature superconductor material 36 forming the Josephson junction 38 between them by lifting up the transfer device 412, releasing the transfer device 412 because of the reduced adhesion.

Independent of whether the second substrate 140 does or does not comprise the semiconductor layer 10, the semiconductor layer 10 and the dielectric layer 20 formed thereover are preferably formed with second pond pads 56. In the process step in which the transfer device 412 with the capacitor layer 130 arranged thereon is placed over the semiconductor layer 10, the transfer device 412 with the capacitor layer 130 arranged thereon is arranged and alignment with respect to the semiconductor layer 10 such that the second bond pad 56 are aligned with the first bond pad 54 so that an electrical connection is formed between the first bond pad 54 and the second bond pad 56.

Preferably, during all the process steps depicted in Fig. 14, the capacitor layer 130 and the layers of high-critical-temperature superconductor material 36 forming the Josephson junction 38 between them are kept in an inert gas atmosphere or in vacuum. According to an embodiment, this is achieved by keeping the capacitor layer 130 and the layers of high-critical-temperature superconductor material 36 forming the Josephson junction 38 between them in a nitrogen-filled glovebox during said process steps.

The fabrication of the capacitor layer 130 used in the method 70 according to any of the foregoing embodiments is achieved using established lithography, etching and deposition techniques on a silicon nitride layer 34. A detailed description of an exemplary fabrication method for the silicon nitride layer 34 is given in EP 4270504 A1 in the context of Fig. 5 to Fig. 11d. In particular, EP 4270504 A1 describes the fabrication of electrically conductive lines 108, 108a, 108b using openings 508 in a silicon nitride layer. This fabrication of electrically conductive lines 108, 108a, 108b is used to fabricate the electrical coupling elements 40 of the current disclosure. Moreover, EP 4270504 A1 describes the fabrication of additional circuitry 510. This fabrication of additional circuitry 510 is used to fabricate the capacitor 32 of the current disclosure, or the first and second electrodes 32a, 32b according to the current disclosure, respectively. The fabrication of additional circuitry 510 is further used to fabricate the first bond pads 54.

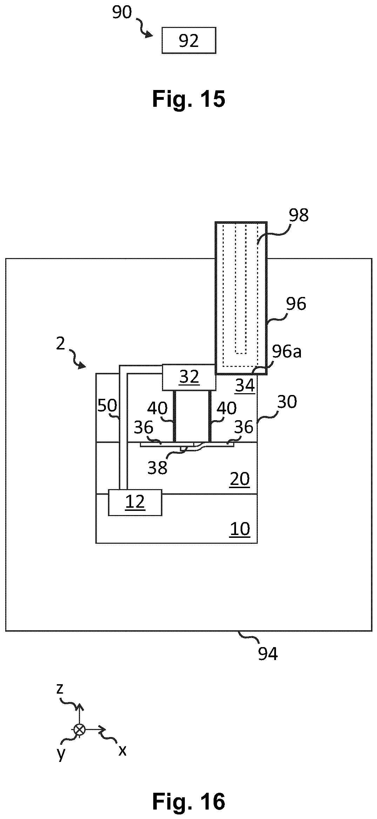

Fig. 15 illustrates the use 90 of the integrated circuit 2 according to any of the embodiments described above. Said use comprises bringing a cooling element 96a having a temperature below 80 K in direct physical contact with the superconducting qubit 30.

Fig. 16 illustrates said use in further detail.

The integrated circuit 2 is kept in a thermal insulation system 94. In the exemplary depicted embodiment, the thermal insulation system 94 is a vacuum cryostat, i.e., a containment kept at a pressure (e.g., at 1000 Pa or less) below ambient pressure. Said containment, according to some embodiments, is evacuated to high vacuum or ultrahigh vacuum. According to some embodiments, the rest-gas atmosphere in the containment consists mostly (i.e., > 50 volume%) of helium.

In the depicted embodiment, the cooling element 96a having the temperature below 80 K is a section 96a of an element 96 with internal channels 98 for flowing liquid helium therethrough. The element 96 extends through the walls of the thermal insulation system 94, such that liquid helium can be flown through the internal flow channels 98 from the outside of the thermal insulation system 94, while the section 96a of the element 96 in direct physical contact with the superconducting qubit 30 is inside of the thermal insulation system 94. In the depicted embodiment, the respective element 96 takes the form of a cold finger 96.

## Claims

1. An integrated circuit (2) comprising:
a semiconductor layer (10) comprising a transistor (12);
a superconducting qubit (30), the superconducting qubit (30) comprising a capacitor (32), a silicon nitride layer (34), and layers of high-critical-temperature superconductor material (36), said layers of high-critical-temperature superconductor material (36) forming a Josephson junction (38) between them, wherein the Josephson junction (38) is electrically coupled to the capacitor (32), and wherein at least a section of the silicon nitride layer (34) is arranged between the capacitor (32) and the Josephson junction (38);
a dielectric layer (20) arranged between the semiconductor layer (10) and the superconducting qubit (30); and
at least one electrical component (50) coupling the superconducting qubit (30) to the transistor (12).

2. The integrated circuit (2) of claim 1, wherein the dielectric layer (20) is arranged above the semiconductor layer (10), and the superconducting qubit (30) is arranged above the dielectric layer (20), in particular, wherein the dielectric layer (20) is arranged above the transistor (12) such that a vertical reference line (v) intersects both the dielectric layer (20) and the transistor (12) and/or wherein the superconducting qubit (30) is arranged above the transistor (12) such that a vertical reference line (v) intersects both the dielectric layer (20) and the transistor (12) and/or wherein the Josephson junction (38) is formed by said layers of high-critical-temperature superconductor material (36) being arranged above one another.

3. The integrated circuit (2) of claim 2, wherein the capacitor (32), the silicon nitride layer (34), and the Josephson junction (38) are arranged above one another, in particular, wherein the silicon nitride layer (34) is arranged above the Josephson junction (38) and the capacitor (32) is arranged above the silicon nitride layer (34).

4. The integrated circuit (2) of any of the preceding claims, wherein each of the layers of high-critical-temperature superconductor material (36) comprises or is a layer of an anisotropic, crystallographically layered material (4), in particular, wherein said anisotropic, crystallographically layered material comprises a c-axis (c) perpendicular to covalently bound atomic layers (62) of the anisotropic, crystallographically layered material and wherein said c-axis (c) is orientated along a vertical direction, in particular, wherein the covalently bound atomic layers (62) of one of the layers of anisotropic, crystallographically layered material (4) are rotated about the c-axis (c) with respect to the covalently bound atomic layers (62) of another one of the layers of an anisotropic, crystallographically layered material (4) at the Josephson junction (38), in particular by an angle being in a range from 38 to 44.9°.

5. The integrated circuit (2) of any of the preceding claims,
wherein the at least one electrical component (50) coupling the superconducting qubit (30) to the transistor (12) comprises an electrically conductive line (52) arranged in the dielectric layer (20) and/or wherein the superconducting qubit (30) is coupled to the transistor (12) through the dielectric layer (20); and/or
wherein the superconducting qubit (30) comprises a first bond pad (54), and wherein the at least one electrical component (50) coupling the superconducting qubit (30) to the transistor (12) comprises the first bond pad (54), in particular, wherein the first bond pad (54) is arranged on the silicon nitride layer (34); and/or
wherein the dielectric layer (20) is provided with a second bond pad (56), and wherein the at least one electrical component (50) coupling the superconducting qubit (30) to the transistor (12) comprises the second bond pad (56), in particular, wherein the second bond pad (56) is arranged on the dielectric layer (20); and/or
wherein the at least one electrical component (50) coupling the superconducting qubit (30) to the transistor (12) comprises an electrically conductive line (58) arranged in the silicon nitride layer (34) and/or wherein the superconducting qubit (30) is coupled to the transistor (12) through the silicon nitride layer (34).

6. The integrated circuit (2) of any of the preceding claims, wherein the superconducting qubit (30) is capacitively coupled to the transistor (12) and/or wherein the at least one electrical component (50) coupling the superconducting qubit (30) to the transistor (12) comprises or is a coupling capacitor (66).

7. The integrated circuit (2) of any of the preceding claims, wherein said capacitor (32) comprises a first electrode (32a) and a second electrode (32b), wherein the integrated circuit (2) further comprises a first interconnect (42) and a second interconnect (42), the first interconnect (42) electrically connecting the first electrode (32a) and a first one of the layers of high-critical-temperature superconductor material (36), and the second interconnect (42) electrically connecting the second electrode (32b) and a second one of the layers of high-critical-temperature superconductor material (36), in particular, wherein said first and second ones of the layers of high-critical-temperature superconductor material (36) form the Josephson junction (38) and/or wherein the first interconnect (42) and/or the second interconnect (42) comprises or is a vertical interconnect (42).

8. The integrated circuit (2) of claim 7, further comprising a horizontal reference plane (h), said horizontal reference plane (h) intersecting both the first electrode (32a) and the second electrode (32b), in particular, wherein the first electrode (32a) and/or the second electrode (32b) extend(s) along said horizontal reference plane (h).

9. The integrated circuit (2) of any of the preceding claims, further comprising an encapsulation (44), said encapsulation (44) encapsulating the layers of high-critical-temperature superconductor material (36) forming the Josephson junction (38), wherein the encapsulation (44) is formed at least in part by the silicon nitride layer (34), in particular, wherein the encapsulation (44) is formed at least in part by the dielectric layer (20) and/or wherein the encapsulation (44) is an air-tight encapsulation.

10. The integrated circuit (2) of any of the preceding claims, wherein the semiconductor layer (10) and/or the superconducting qubit (30) is in direct physical contact with the dielectric layer (20).

11. The integrated circuit (2) of any of the preceding claims, wherein the semiconductor layer (10) comprises a heating element (14) adapted to provide heat to the transistor (12), in particular, wherein the heating element (14) is arranged in a vicinity of the transistor (12).

12. The integrated circuit (2) of any of the preceding claims,
wherein the at least one electrical component (50) coupling the superconducting qubit (30) to the transistor (12) couples a gate (18) of the transistor (12) to the capacitor (32), in particular wherein the at least one electrical component (50) couples the gate (18) of the transistor (12) to the first electrode (32a) or to the second electrode (32b) of the capacitor (32).

13. The integrated circuit (2) of any of the preceding claims,
wherein the superconducting qubit (30) is coupled to the transistor (12) via a microwave resonator (68) and/or wherein the at least one electrical component (50) coupling the superconducting qubit (30) to the transistor (12) comprises or is at least one microwave resonator (68).

14. A method (70) for fabricating an integrated circuit (2), said method comprising:
providing (72) a semiconductor layer (10) and a dielectric layer (20) over the semiconductor layer (10), the semiconductor layer (10) comprising a transistor (12);
providing (74) a capacitor layer (130) separate from the semiconductor layer (10) and separate from the dielectric layer (20), the capacitor layer (130) comprising a silicon nitride layer (34), a capacitor (32) and electrical coupling elements (40), the capacitor (32) comprising a first electrode (32a) and a second electrode (32b), wherein the electrical coupling elements (40) comprise a first electrical coupling element in electrical contact with the first electrode (32a) and a second electrical coupling element in electrical contact with the second electrode (32b);
providing (76) layers of high-critical-temperature superconductor material (36), said layers of high-critical-temperature superconductor material (36) forming a Josephson junction (38) between them;
arranging (78) the capacitor layer (130) and the layers of high-critical-temperature superconductor material (36) over the semiconductor layer (10) and the dielectric layer (20), such that the capacitor (32), the silicon nitride layer (34), and the layers of high-critical-temperature superconductor material (36) form a superconducting qubit (30) and such that the dielectric layer (20) is arranged between the semiconductor layer (10) and the superconducting qubit (30), wherein in the superconducting qubit (30) the Josephson junction (38) is electrically coupled to the capacitor (32) through the first electrical coupling element and the second electrical coupling element and at least a section of the silicon nitride layer (34) is arranged between the capacitor (32) and the Josephson junction (38).

15. Use (90) of the integrated circuit (2) according to any of claims 1 to 13, wherein said use comprises bringing a cooling element (98a) having a temperature below 80 K in direct physical contact with the superconducting qubit (30).
